Europäisches Patentamt

European Patent Office

Office européen des brevets

(11) Numéro de publication: **0 267 129 B1**

(12) **FASCICULE DE BREVET EUROPEEN**

(45) Date de publication de fascicule du brevet:
24.07.91

(21) Numéro de dépôt: 87420286.4

(22) Date de dépôt: 23.10.87

(51) Int. Cl.5: **H02M 1/12,** H04B 15/02,
H05K 9/00

(54) **Convertisseur statique comportant un filtre de protection contre les perturbations haute-fréquence.**

(30) Priorité: **05.11.86 FR 8615620**

(43) Date de publication de la demande:
**11.05.88 Bulletin 88/19**

(45) Mention de la délivrance du brevet:
**24.07.91 Bulletin 91/30**

(84) Etats contractants désignés:
**AT BE CH DE ES GB IT LI NL SE**

(56) Documents cités:

**ELEKTRONIK, vol. 33, no. 2, janvier 1984, pages 66-77, Munich, DE; E. OGROSKE: "Die störungsfreie Stromversorgung moderner Elektronik"**

**ELEKTROTECHNIK, vol. 57, no. 8, 11 avril 1975, pages 12-15; H. KUNATH: "Thyristor und Triac als Störquelle"**

(73) Titulaire: **MERLIN GERIN**
**Rue Henri Tarze**
**F-38050 Grenoble Cédex(FR)**

(72) Inventeur: **Fiorina, Jean-Noel**
**Merlin Gerin Rue Henri Tarze**
**F-38050 Grenoble Cedex(FR)**
Inventeur: **Denis, Hervé**
**Merlin Gerin Rue Henri Tarze**
**F-38050 Grenoble Cedex(FR)**

(74) Mandataire: **Kern, Paul et al**
**Merlin Gerin Sce. Brevets 20, rue Henri Tarze**
**F-38050 Grenoble Cédex(FR)**

Rank Xerox (UK) Business Services

## Description

L'invention concerne un convertisseur statique comportant un filtre de protection contre les perturbations haute-fréquence, le convertisseur statique comportant une enveloppe externe reliée à la terre par un conducteur de protection, des câbles d'entrée, reliés respectivement au réseau et à une batterie d'accumulateurs et un câble de sortie relié à un dispositif d'utilisation.

Les parasites haute-fréquence dus aux commutations des semiconducteurs de puissance, notamment des thyristors, dans les convertisseurs statiques peuvent créer dans le réseau des perturbations qu'il est nécessaire de limiter au maximum.

A cet effet, il est connu d'utiliser des filtres d'insertion reliés au châssis de l'appareil. Ces filtres sont des filtres LC passe-bas classiques, par exemple à structure en II, insérés en ligne à l'entrée et à la sortie du convertisseur, entre les câbles d'entrée ou de sortie, et le châssis du convertisseur, lui-même relié à la terre du bâtiment dans lequel il est installé. (Elektronik, vol.33, n° 2, janvier 1984, pages 66-77).

Dès que la puissance du convertisseur atteint quelques dizaines de KVA, ces filtres nécessitent l'utilisation de condensateurs de valeur élevée. Les courants réinjectés par l'intermédiaire de ces condensateurs dans le conducteur de protection reliant le châssis de l'appareil à la terre sont alors très vite supérieurs aux valeurs admissibles. En effet, ces courants doivent rester limités à des valeurs faibles de quelques milliampères, afin de ne pas faire déclencher de façon intempestive les dispositifs contrôleurs d'isolement, en particulier les disjoncteurs différentiels, situés en amont du convertisseur. Or, avec des condensateurs de valeur élevée, les courants, notamment dérivés de l'alimentation du réseau, réinjectés dans le conducteur de protection sont vus par les contrôleurs d'isolement comme un défaut permanent. Par ailleurs, une augmentation trop importante du seuil de déclenchement de ces contrôleurs conduirait à masquer les défauts à la terre réels et à réduire de façon inacceptable la protection des personnes en contact avec ce matériel.

De plus, le filtrage du vrai mode commun est très difficile à obtenir avec les dispositifs d'insertion en ligne connus et il est difficile de concilier les exigences liées à la limitation des perturbations, à savoir une inductance de forte valeur dans le filtre LC classique, et les exigences de faible dimensionnement en raison du courant nominal que l'inductance doit supporter.

L'invention a pour but un convertisseur statique comportant un filtre permettant de limiter les perturbations haute-fréquence réinjectées sur les câbles arrivant et partant du convertisseur statique, notamment dans les convertisseurs statiques de moyenne et haute puissance, et ne présentant pas ces inconvénients.

Le convertisseur statique selon l'invention est caractérisé en ce que le filtre de protection comporte un plan de référence interne, électriquement isolé de l'enveloppe et servant de plan de masse à tous les éléments internes du convertisseur, et des condensateurs de filtrage reliant respectivement les câbles d'entrée et de sortie audit plan de référence interne.

D'autres avantages et caractéristiques de l'invention ressortiront plus clairement de l'exposé qui va suivre, illustré à titre d'exemple non limitatif et représenté aux dessins annexés dans lesquels :

- la figure 1 représente, sous forme schématique, un convertisseur statique comportant un filtre de protection selon l'invention ;
- la figure 2 représente, également sous forme schématique, un mode de réalisation particulier d'un plan de référence interne d'un filtre de protection selon l'invention ;
- la figure 3 représente plus en détail, en coupe, le support des bornes de connexion des câbles d'entrée et de sortie du convertisseur au filtre de protection selon l'invention.

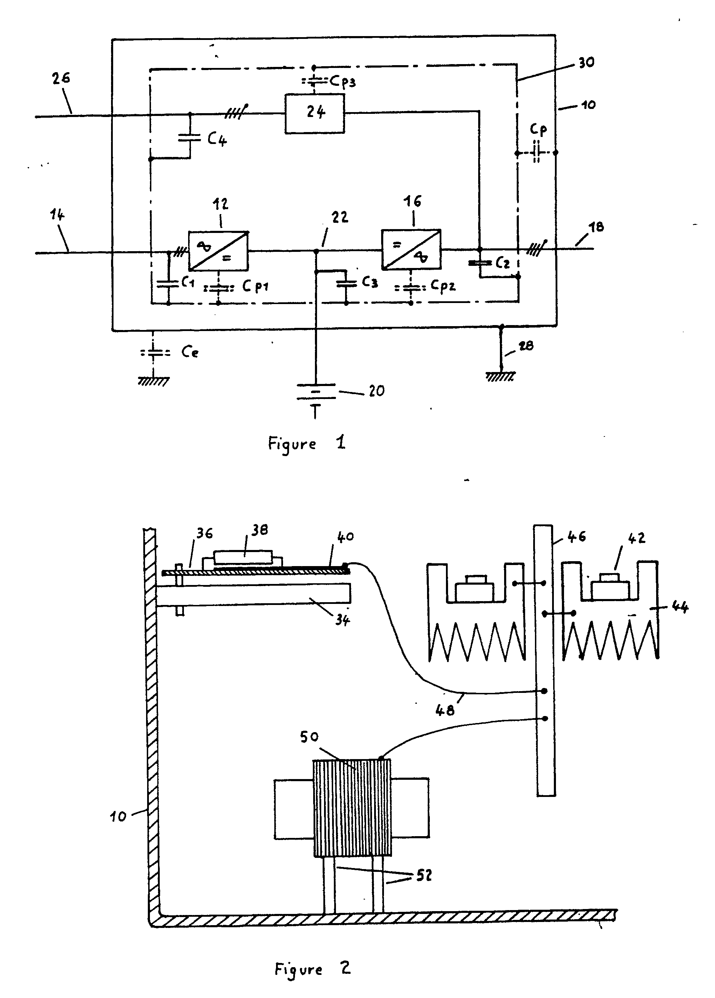

Le convertisseur statique représenté sur la figure 1 comporte, en série dans une enveloppe externe 10, un redresseur-chargeur 12 et un onduleur 16. Le redresseur-chargeur 12 est relié par un câble d'entrée 14, triphasé, au réseau d'alimentation principal et l'onduleur 16 est relié par un câble de sortie 18, triphasé avec neutre, au dispositif d'utilisation. Une batterie d'accumulateurs 20 est connectée au câble 22 reliant le redresseur-chargeur 12 à l'onduleur 16. Un circuit de dérivation 24, relié par un câble d'entrée 26, triphasé avec neutre, à un réseau d'alimentation de secours, est également connecté au câble de sortie 18. L'enveloppe externe 10 du convertisseur est reliée à la terre du bâtiment par un conducteur de protection 28.

Un tel convertisseur statique est bien connu des spécialistes et il n'apparaît pas utile de décrire plus en détail ni sa structure, ni son fonctionnement.

Le filtre du convertisseur selon l'invention est constitué par des condensateurs C1, C2, C3 et C4, reliant respectivement les câbles 14, 18, 22 et 26 à un plan de référence interne 30 qui n'est pas relié à la terre et se trouve par conséquent à un potentiel de référence, flottant, indépendant du potentiel de terre.

Des capacités parasites existent, par ailleurs, entre les divers constituants de puissance du convertisseur et le plan de référence interne 30. Sur la figure 1, on a représenté en pointillé les capacités parasites CP1, CP2, et CP3 existant entre le plan de référence interne 30 et le redresseur-chargeur 12, l'onduleur 16 et le circuit de dérivation 24 respectivement, ainsi que la capacité parasite CP existant entre le plan de référence interne et l'enveloppe externe 10 et la capacité parasite Ce existant entre l'enveloppe 10 et le potentiel de terre.

Les parasites dûs aux commutations des semi-conducteurs de puissance des circuits 12, 16 ou 24 sont donc interceptés par le plan de référence 30 par l'intermédiaire des condensateurs de filtrage C1 à C4 et des capacités parasites CP1 à CP3. L'essentiel des perturbations n'est donc pas retransmis vers l'extérieur par les câbles d'entrée et/ou de sortie, et le plan de référence 30 n'étant pas relié à l'enveloppe 10, les perturbations ne sont pas non plus transmises au conducteur de protection 28.

Les courants haute-fréquence, qui sont néanmoins réinjectés vers la terre du bâtiment par l'intermédiaire des capacités parasites CP et Ce et qui peuvent, en conséquence, se reboucler à travers le conducteur de protection 28 pour propager le mode commun sont très faibles, le plan de référence interne 30 étant à un potentiel virtuel très proche de la terre en haute-fréquence. Le dispositif ainsi réalisé, qui de plus ne comporte pas d'impédance contrairement aux filtres d'insertion classiques, apporte donc également une solution au filtrage du vrai mode commun.

Dans la pratique, le plan de référence interne 30 n'est pas réalisé sous la forme d'un écran interne comme schématisé sur la figure 1, mais il est constitué par divers éléments reliés entre eux. Un mode de réalisation particulier des divers éléments pouvant former le plan de référence est illustré de façon schématique sur la figure 2.

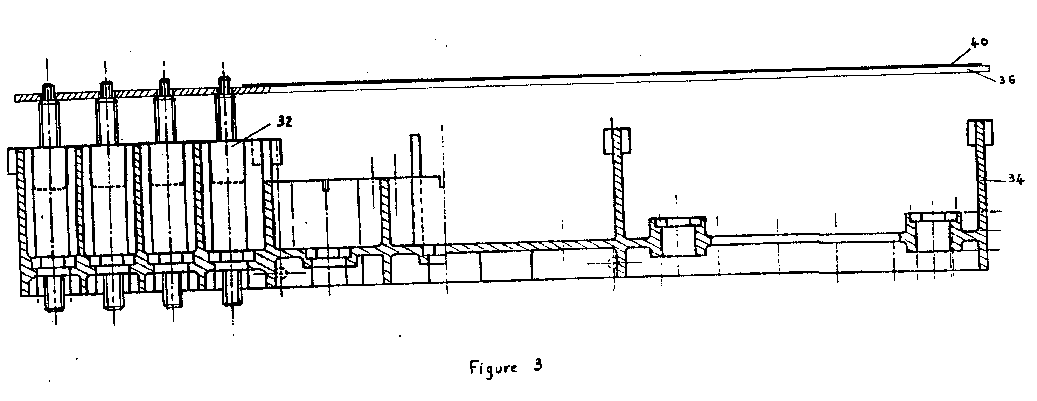

Les câbles 14, 18, 22 et 26 d'entrée et de sortie sont reliés aux condensateurs de filtrage C1 à C4, ainsi qu'aux divers éléments (12, 16, 24) qui leur sont respectivement associés par l'intermédiaire de bornes de connexion 32. Comme représenté plus en détail sur la figure 3, ces bornes de connexion 32 sont montées dans un support isolant 34 et supportent un circuit imprimé 36 portant les condensateurs de filtrage 38 (C1 à C4). Le plan de référence 30 est constitué en partie par une métallisation 40 d'une partie, aussi importante que possible, de l'une des faces du circuit imprimé. Ainsi que représenté sur la figure 2, les semi-conducteurs 42 des constituants de puissance 12, 16 et 24 du convertisseur, en boîtiers plastiques à semelle électriquement isolante, sont montés sur des radiateurs 44 qui sont également connectés à la métallisation du circuit imprimé servant de plan de référence. Cette connexion se fait, de préférence, par l'intermédiaire d'une plaque métallique 46 disposée à proximité des radiateurs et à laquelle ils sont reliés, la plaque métallique étant elle-même reliée par un conducteur 48 à la métallisation 40 du circuit imprimé et constituant avec elle le plan de référence interne 30.

De même, les circuits magnétiques des éléments bobinés 50 - transformateurs et inductances fixés par des éléments isolants 52 à l'enveloppe 10 du convertisseur - sont reliés au plan de référence, de préférence par l'intermédiaire de la plaque métallique 46 ou, éventuellement, par l'intermédiaire d'une seconde plaque métallique connectée à la première. Ainsi les plans de masse des divers éléments internes du convertisseur sont reliés à la métallisation 40 par l'intermédiaire d'au moins une plaque métallique 46.

Pour les appareils de forte puissance, les semi-conducteurs, qui ne sont plus en boîtiers plastiques à semelle isolante, ne sont pas isolés électriquement des radiateurs associés. Il n'est alors plus possible de relier directement les radiateurs au plan de référence. On utilise alors un écran métallique placé sans contact au plus près des radiateurs et relié au plan de référence.

Il est bien évident que le filtre selon la présente invention est utilisable dans les alimentations statiques sans coupure de tout type.

**Revendications**

1. Convertisseur statique comportant un filtre de protection contre les perturbations haute-fréquence, le convertisseur statique comportant une enveloppe externe (10) reliée à la terre par un conducteur de protection (28), des câbles d'entrée (14, 26, 22) reliés respectivement au réseau et à une batterie d'accumulateurs (20) et un câble de sortie (18) relié à un dispositif d'utilisation, convertisseur caractérisé en ce que le filtre de protection comporte un plan de référence interne (30), électriquement isolé de l'enveloppe (10) et servant de plan de masse à tous les éléments internes du convertisseur, et des condensateurs de filtrage (C1 - C4) reliant respectivement les câbles d'entrée(14, 26, 22) et de sortie (18) audit plan de référence interne (30).

2. Convertisseur selon la revendication 1, caractérisé en ce que le plan de référence interne (30) est constitué, d'une part, par une métallisation (40) d'une face d'un circuit imprimé (36) portant les condensateurs de filtrage (C1 - C4, 38) et, d'autre part, par au moins une plaque métallique (46), reliée à ladite métallisation par un conducteur (48) et à laquelle sont connectés les plans de masse des divers éléments internes (44, 50) du convertisseur.

3. Convertisseur selon la revendication 2, caractérisé en ce que ledit circuit imprimé (36) est porté par des bornes (32) de connexion des câbles d'entrée et de sortie (14, 18, 22, 26) du convertisseur, montées dans un support isolant (34) disposé à l'intérieur de l'enveloppe (10).

## Claims

1. A static converter comprising a filter protecting against high-frequency disturbances, the static converter comprising an external housing (10) earthed by a protective conductor (28), input cables (14, 26, 22) connected respectively to the mains and to a battery bank (20), and an output cable (18) connected to a user device, converter, characterized in that the protection filter comprises an internal reference plane (30), electrically insulated from the housing (10) and acting as a ground plane for all the internal converter elements, and filtering capacitors (C1 - C4) respectively connecting the input (14, 26, 22) and output (18) cables to said internal reference plane (30).

2. The static converter according to claim 1, characterized in that the internal reference plane (30) is made up on the one hand by a metallization (40) of one face of a printed circuit (36) bearing the filtering capacitors (C1 - C4, 38), and on the other hand by at least one metal plate (46) connected to said metallization by a conductor (48) and to which the ground planes of the various internal converter elements (44, 50) are connected.

3. The static converter according to claim 2, characterized in that said printed circuit (36) is supported by connection terminals (32) of the converter input and output cables (14, 18, 22, 26), mounted in an insulating support disposed inside the housing (10).

## Patentansprüche

1. Statischer Konverter mit Schutzfilter gegen Hochfrequenz-Störungen, wobei der statische Konverter eine äussere Hülle (10) aufweist, die mittels einem Schutzleiter (28) mit der Erde verbunden ist, sowie Eingangskabel (14, 26, 22), die mit einem Netz bzw. einer Akkumulatoren-Batterie (20) verbunden sind, und ein mit einer Benutzungsvorrichtung verbundenes Ausgangskabel (18), Konverter, dadurch gekennzeichnet, dass der Schutzfilter eine innere Referenz-Ebene (30) aufweist, die elektrisch von der Hülle (10) isoliert ist und als Masse-Ebene für alle inneren Elemente des Konverters dient, und Filter-Kondensatoren (C1-C4), welche die Eingangskabel (14, 26, 22) bzw. Ausgangskabel (18) mit der genannten inneren Referenz-Ebene (30) verbinden.

2. Konverter gemäss Anspruch 1, dadurch gekennzeichnet, dass die innere Referenz-Ebene (30) einerseits durch die Metallisierung einer Seite einer die Filter-Kondensatoren (C1-C4, 38) tragenden gedruckten Schaltung (36) gebildet wird, und andererseits durch mindestens eine Metallplatte (46), die mit dem genannten Metallüberzug durch einen Leiter (48) verbunden ist und mit der die Masse-Ebenen der verschiedenen internen Elemente (44, 50) des Konverters verbunden sind.

3. Konverter gemäss Anspruch 2, dadurch gekennzeichnet, dass die genannte gedruckte Schaltung (36) von Anschlussklemmen (32) der Eingangs- und Ausgangskabel (14, 18, 22, 26) des Konverters getragen wird, welche in einem Isolierträger (34) montiert sind, der im Innern der Hülle (10) angeordnet ist.

Figure 1

Figure 2

5

Figure 3